# FASCICULE DE BREVET EUROPEEN

(11) **EP 2 834 655 B1**
(45) Date de publication et mention de la délivrance du brevet: **11.01.2017**
(21) Numéro de dépôt: 13713898.8
(22) Date de dépôt: 03.04.2013
(51) Int. Cl.: G01R 31/30, G06F 11/18, G06F 11/16, G01R 31/317

(54) **PROCÉDÉ DE GESTION DE LA DÉGRADATION PARTIELLE DE COMPOSANTS ÉLECTRONIQUES, ARCHITECTURE ET PROCESSEUR METTANT EN OEUVRE LE PROCÉDÉ**
VERFAHREN ZUR HANDHABUNG DES PARTIELLEN ABBAUS VON ELEKTRONISCHEN BAUTEILEN, ARCHITEKTUR SOWIE PROZESSOR ZUR UMSETZUNG DES VERFAHRENS
METHOD FOR MANAGING THE PARTIAL DEGRADATION OF ELECTRONIC COMPONENTS, ARCHITECTURE AND PROCESSOR IMPLEMENTING THE METHOD

(30) Priorité: 03.04.2012 FR 1200986
(43) Date de publication de la demande: 11.02.2015
(73) Titulaire: THALES, 92200 Neuilly-sur-Seine (FR)
(72) Inventeur: GRASSET, Arnaud, F-91767 Palaiseau (FR)
(74) Mandataire: Lavoix
(86) Numéro de dépôt international: PCT/EP2013/057018
(87) Numéro de publication internationale: WO 2013/150068

(56) Documents cités:
- EP-A1- 2 060 924
- WO-A1-2004/111667
- US-B1- 7 671 579
- GUPTA S ET AL: "The StageNet fabric for constructing resilient multicore systems", MICROARCHITECTURE, 2008. MICRO-41. 2008 41ST IEEE/ACM INTERNATIONAL SYMPOSIUM ON, IEEE, PISCATAWAY, NJ, USA, 8 novembre 2008 (2008-11-08), pages 141-151, XP031442402, ISBN: 978-1-4244-2836-6 cité dans la demande
- BARDIA ZANDIAN ET AL: "WearMon: Reliability monitoring using adaptive critical path testing", DEPENDABLE SYSTEMS AND NETWORKS (DSN), 2010 IEEE/IFIP INTERNATIONAL CONFERENCE ON, IEEE, PISCATAWAY, NJ, USA, 28 juin 2010 (2010-06-28), pages 151-160, XP031730042, ISBN: 978-1-4244-7500-1

## Description

L'invention concerne un procédé de gestion de la dégradation partielle de composants électroniques. Il est également proposé une architecture de traitement de données et un processeur adaptés à la mise en oeuvre de ce procédé de gestion.

De nos jours, la fiabilité et la durée de vie des circuits intégrés constituent des préoccupations croissantes. La tendance actuelle est de réduire la finesse de la gravure des technologies CMOS notamment. La technologie CMOS, (ou Complementary Metal Oxyd Semi-conductor selon son acronyme anglais), est une technologie de fabrication de composants électroniques. Par extension, l'ensemble des composants fabriqués selon cette technologie sont désignés par le terme technologie CMOS. Ces composants sont en majeure partie des portes logiques (NAND, NOR ou autres) mais peuvent être également utilisés comme des résistances variables.

Cette tendance à la réduction s'accompagne d'une augmentation des variations observées à l'issue des procédés de fabrication, ainsi que d'une accentuation des phénomènes d'usure. Il a ainsi été prédit que la durée de vie des circuits intégrés pourrait descendre à des valeurs inférieures à dix ans dans le cadre de technologies particulièrement avancées. Jusqu'à présent, cette réduction de la durée de vie était traitée lors de la conception de ces technologies et des circuits intégrés en prenant des marges sur le temps d'appropriation des cellules de vie utilisées. Une telle approche ne semble plus envisageable. En effet, l'accentuation des phénomènes d'usure et l'augmentation des variations conduisent à des niveaux de fiabilité et de durée de vie des circuits intégrés numériques qui sont trop faibles pour tirer un bénéfice de ces nouvelles technologies.

L'usure d'un circuit intégré se traduit notamment par une dégradation progressive des temps de propagation des cellules logiques. Cette dégradation progressive entraîne l'apparition de chemins avec des temps de propagation supérieurs à la période d'horloge. Les entrées des registres en sortie des chemins ne seront alors pas stables au moment de leurs captures par un registre. Ces erreurs sont qualifiées d'erreurs temporelles. Il est connu du document M.NICOLAIDIS, "Time Redundancy Based Soft Error Tolerance to Rescue Nanometer Technologies", Proceedings of the 17th IEEE VLSI Test Symposium, pages 86 à 94 (1999), document XP 010334890, une technique consistant à associer une deuxième bascule à
chaque bascule en sortie d'un circuit combinatoire. Cette bascule capture l'entrée du registre avec un certain retard. Une valeur identique sur les deux bascules indique que l'entrée est restée stable au moment du front d'horloge. Des valeurs différentes indiquent que l'entrée n'est pas restée stable du fait de l'allongement du temps de propagation dans la logique combinatoire.

Cependant, cette solution impliquant l'usage de registres « fantômes » pour la détection d'erreurs temporelles concerne avant tout les applications grand public. De telles architectures n'ont pas de redondance spatiale, ce qui implique qu'elles ne peuvent supporter des fautes permanentes.

Il est également connu des architectures avec de la redondance spatiale servant à détecter ou à masquer des fautes. Les plus connues sont les architectures DMR ou TMR. DMR est l'acronyme anglais pour « Dual Modular Redundancy » tandis que TMR est l'acronyme anglais pour « Triple Modular Redundancy ». Il est également connu des processeurs double-coeur qui peuvent fonctionner en mode maître-esclave dit « lockstep ». Ce mode lockstep correspond au fait que deux lignes fonctionnent de façon synchrone en exécutant les mêmes opérations. Il en résulte que les sorties de chaque étage des lignes doivent être identiques. Une comparaison entre chacune des sorties des étages indique si une erreur s'est produite dans un étage de l'une des lignes. Si une erreur est détectée les mesures appropriées peuvent alors être mises en place pour, soit la corriger, soit la contenir.

Néanmoins, ces architectures de ligne basées sur la redondance spatiale présentent le défaut d'être encombrantes.

Il est également connu d'utiliser la redondance spatiale pour permettre une reconfiguration de l'architecture lorsqu'une faute permanente a été détectée. Cette reconfiguration peut notamment être effectuée dans le cadre d'un autotest (désigné en anglais par l'acronyme « BIST » pour Built-In Self Test). A titre d'exemple, le document B.F. ROMANESCU et D.J. SORIN Core Cannibalization Architecture : Improving Lifetime Chip Performance for Multicore Processors in the Presence of Hard Faults, PACT'08 : Proceedings of the 17th International Conférence on Parallel Architectures and Compilation Techniques, pages 43 à 51. (2008), document XP 055289891, introduit de la logique de multiplexage
entre des coeurs de processeurs. Cela permet que certains composants de certaines lignes puissent être changés par d'autres composants d'autres lignes en cas de faute permanente. Le document S. GUPTA, S. FENG, A. ANSARI, J. BLOME, et S. MAHLKE, « The StageNet Fabric for Constructing Résilient Multicore Systems », MICRO'08 : Proceedings of the 2008 41st IEEE/ACM International Symposium on Microarchitecture, 2008, pages 141 à 151, document XP 03141675, est un autre exemple d'utilisation de la redondance spatiale pour
la reconfiguration d'une architecture. Il est en effet, proposé une architecture multicoeur avec des lignes répliquées dans lesquelles des réseaux de commutation sont insérés entre les étages des lignes.

Néanmoins, ces deux solutions ne permettent pas de gérer la dégradation partielle d'un composant, puisqu'elles considèrent que, soit le composant fonctionne, soit il ne fonctionne pas.

Il est également connu du document WO 2004/111 667 A1 un circuit intégré qui comprend un circuit de surveillance du temps d'extinction. Le circuit de surveillance du temps d'extinction comprend un chemin dupliqué, ayant les mêmes caractéristiques que le chemin logique surveillé. Le chemin dupliqué reçoit un signal pulsé de référence à partir d'une unité de génération de référence. Le signal pulsé de référence est synchronisé avec le signal d'horloge, et passe à travers le chemin dupliqué vers une unité de contrôle de référence. Dans un mode de fonctionnement normal dans lequel le temps d'extinction est garanti, le signal d'horloge échantillonne le signal pulsé de référence, de telle sorte qu'aucun signal d'interruption ne soit généré sur la ligne d'interruption. Cependant, dans le cas où l'unité de contrôle de référence est cadencée par le signal d'horloge avant réception du signal pulsé de référence par l'intermédiaire du chemin dupliqué, un signal d'interruption est généré sur la ligne d'interruption, ce qui indique que le temps d'extinction ne peut pas être garanti.

Il existe donc un besoin pour un procédé de gestion de la dégradation partielle des composants électroniques faisant partie d'une architecture de traitement de données.

Pour cela, il est proposé un procédé de gestion de la dégradation partielle de composants électroniques faisant partie d'une architecture de traitement de données comportant une pluralité de lignes de traitement de données dont une première ligne de traitement de données, une deuxième ligne de traitement de données, au moins les première et deuxième lignes étant redondantes et munies de registres de mémorisation en correspondance. Le procédé comprend une étape d'introduction dans au moins un registre de la deuxième ligne d'au moins un signal électrique identique à un signal électrique présent dans la première ligne par envoi d'un signal électrique présent dans la première ligne dans un registre de la deuxième ligne. La première ligne et la deuxième ligne sont munies d'un commutateur adapté à orienter les signaux d'une ligne vers l'une des deux lignes ou les deux lignes, l'étape d'introduction étant réalisée à l'aide du commutateur. L'étape d'introduction comprend à la fois l'introduction d'un signal de la première ligne dans un registre de la deuxième ligne et l'introduction du même signal de la première ligne dans le registre de la première ligne en correspondance avec le registre de la deuxième ligne. Le procédé comporte, en outre, une étape de comparaison des signaux électriques en sortie des deux registres correspondants et de détermination de la dégradation partielle d'au moins un composant électronique de la première ligne, à partir de cette comparaison.

Selon d'autres caractéristiques de l'invention, prises séparément ou en combinaison :
- le procédé comporte une étape de déphasage d'une horloge contrôlant un registre de la deuxième ligne par rapport à une horloge contrôlant un registre correspondant de la première ligne et d'un envoi de l'horloge déphasée vers le registre de la deuxième ligne, l'étape de détermination de la dégradation partielle comportant une détermination du temps de réponse du composant considéré,
- le déphasage de l'horloge correspond au temps de réponse attendu pour le composant électronique testé,
- l'étape de détermination de la dégradation partielle comporte également une étape de comparaison du temps de réponse déterminé du composant au temps de réponse attendu et une étape de détection d'un vieillissement du composant testé dans le cas où le temps déterminé est supérieur au temps de réponse attendu,
- le procédé comprend en outre une étape de compensation de la différence de temps entre le temps déterminé et le temps de réponse attendu pour le composant,
- l'étape de compensation est réalisée par échange des signaux d'entrées entre deux registres en correspondance des deux lignes, un signal de la première ligne alimentant le registre de la deuxième ligne et le signal correspondant de la deuxième ligne alimentant le registre correspondant de la première ligne,
- l'étape de compensation est réalisée par échange des signaux d'horloge entre deux registres en correspondance des deux lignes, un signal identique à un signal d'horloge de la première ligne alimentant le registre de la deuxième ligne et un signal identique à un signal d'horloge de la deuxième ligne alimentant le registre correspondant de la première ligne,
- l'architecture de traitement de données comporte une troisième ligne redondante avec les première et deuxième lignes, les trois lignes étant munies de registres et de commutateurs en correspondance, les registres et les commutateurs sont pourvus d'au moins une entrée et un sortie et les entrées des commutateurs sont reliés à des sorties des registres.

L'invention a également pour objet une architecture de traitement de données comportant une pluralité de lignes de traitement de données dont une première ligne de traitement de données, et une deuxième ligne de traitement de données, au moins les première et deuxième lignes étant redondantes et munies de registres de mémorisation en correspondance, l'architecture étant adaptée pour la mise en oeuvre du procédé comme décrit précédemment.

L'invention propose également un processeur comportant plusieurs coeurs, chaque coeur comportant une architecture telle que décrite précédemment.

D'autres caractéristiques et avantages de l'invention apparaîtront à la lecture de la description détaillée qui suit de modes de réalisation de l'invention, donnée à titre d'exemple uniquement et en référence aux dessins qui montrent :
- figure 1, une vue d'un exemple d'architecture de traitement de données;
- figure 2, un schéma d'un commutateur selon l'état de la technique ;
- figure 3, un schéma d'une architecture de traitement de données mettant en oeuvre un exemple de procédé de gestion selon l'invention ;
- figure 4, un schéma d'une architecture de traitement de données mettant en oeuvre un autre exemple de procédé de gestion selon l'invention ;
- figure 5, un schéma d'une architecture de traitement de données mettant en oeuvre un autre exemple de procédé de gestion selon l'invention ;
- figure 6, un schéma d'une utilisation alternative du schéma de la figure 5 selon l'invention ;
- figure 7, un schéma d'un exemple d'une architecture de traitement de données comportant trois lignes selon l'invention, et
- figure 8, un exemple d'architecture simplifiée d'un processeur double coeur mettant en oeuvre le procédé de gestion proposé.

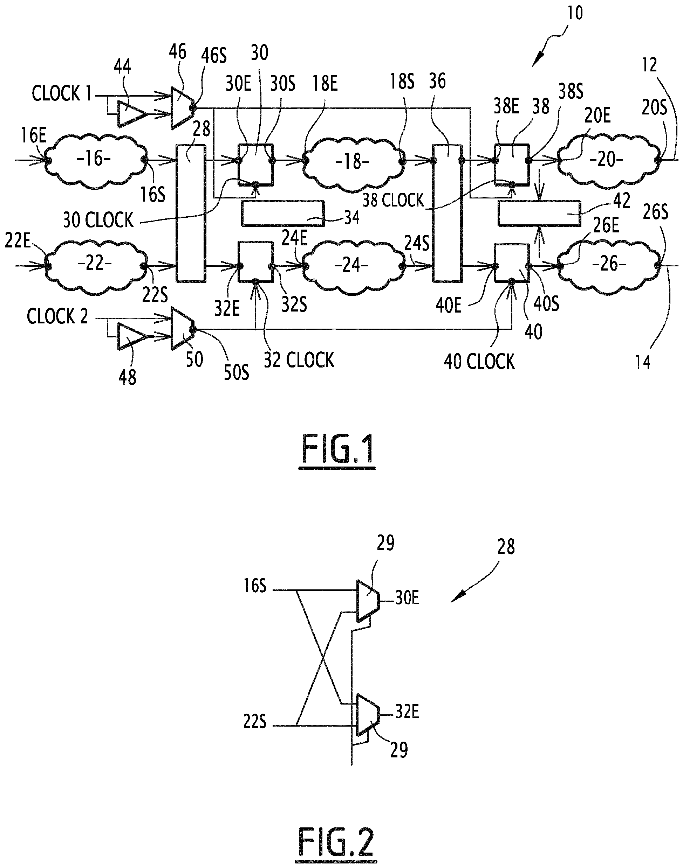

La figure 1 montre un schéma d'une architecture 10 de traitement de données comportant une première ligne 12 de traitement de données et une deuxième ligne 14 de traitement de données. A titre d'exemple, l'architecture 10 traite des données numériques uniquement.

En outre, l'architecture 10 est une architecture de type parallèle. Cela implique que les lignes 12 et 14 sont redondantes.

Dans l'exemple de la figure 1, les lignes 12 et 14 sont plus spécifiquement des pipelines composés d'étages. Un pipeline est un élément d'un circuit électronique dans lequel les données avancent les unes derrière les autres, au rythme d'un signal d'horloge. Dans la microarchitecture d'un microprocesseur, c'est plus précisément l'élément dans lequel l'exécution des instructions est découpée en étages.

Pour le cas de la figure 1, chaque ligne 12 et 14 comporte trois étages. Un étage est un ensemble de composants électriques permettant d'effectuer des opérations sur des données. Les opérations sont de diverses natures selon les modes de réalisation envisagés. A titre d'illustration, il peut s'agir d'effectuer des opérations logiques sur les données (AND, OR...) ou de les transférer vers des registres de mémorisation. Ainsi, la ligne 12 comporte successivement un premier étage 16, un deuxième étage 18 et un troisième étage 20. Similairement, la deuxième ligne 14 comprend un premier étage 22, un deuxième étage 24 et un troisième étage 26.

Chaque étage dont le signe de référence est le nombre N est muni d'une entrée notée NE et d'une sortie notée NS. Ainsi, pour la première ligne 12, le premier étage 16 comprend une entrée 16E et une sortie 16S, le deuxième étage 18, une entrée 18E et une sortie 18S et le troisième étage 20 une entrée 20E et une sortie 20S. Similairement, pour la deuxième ligne 14, le premier étage 22 comprend une entrée 22E et une sortie 22S, le deuxième étage 24, une entrée 24E et une sortie 24S et le troisième étage 26 une entrée 26E et une sortie 26S.

A titre d'exemple, dans le cas où l'étage N considéré effectue des opérations logiques sur les données d'entrées, par exemple un « ET » logique, cela signifie que pour un signal « 0 » et « 1 » en entrée sur l'entrée NE, le signal de sortie sur la sortie NS est un « 0 ». Au contraire, si l'étage N est dédié à l'opération « OU » logique, pour le même signal en entrée NE, le signal de sortie sur la sortie NS est un « 1 ».

En outre, il apparaît que l'entrée 16E est l'entrée de la ligne 12 et que la sortie 20S du dernier étage (en l'occurrence le troisième étage 20) est la sortie de la ligne 12. Similairement, l'entrée 22E et la sortie 26S sont respectivement l'entrée et la sortie de la deuxième ligne 14. Dans cette configuration, les lignes 12 et 14 fonctionnent soit en mode « lock-step » (exécution des mêmes opérations sur les deux lignes en parallèle), soit de façon indépendantes (exécution d'opérations différentes sur les deux lignes).

Les lignes 12 et 14 sont redondantes. Les composants électroniques des premiers étages 16 et 22 sont donc correspondants. Cela signifie que, pour un même signal introduit dans les entrées, le signal sur la sortie 16S du premier étage 16 de la première ligne 12 a des caractéristiques similaires au signal de la sortie 22S du premier étage 22 de la deuxième ligne 14.

Les mêmes remarques s'appliquent respectivement pour les composants électroniques des deuxièmes étages 18 et 24 des deux lignes 12 et 14 ainsi que pour ceux des troisièmes étages 20 et 26. Il en résulte que, pour un même signal introduit aux entrées 16E et 18E, l'emploi de la ligne 12 ou de la ligne 14 conduit à l'obtention du même signal aux sorties 16S et 22S. Cela correspond bien au fait que les deux lignes 12 et 14 sont redondantes.

La première ligne 12 et la deuxième ligne 14 comportent deux commutateurs. Les commutateurs sont placés en sortie de chaque étage. Les commutateurs permettent d'orienter les signaux d'une ligne vers l'une des deux lignes ou les deux.

Un commutateur 28 est ainsi placé en sortie des étages 16 et 22. Il est relié aux sorties 16S et 22S. Le commutateur 28 comporte deux sorties, une première reliée à la première ligne 12 et, une deuxième à la deuxième ligne 14.

En considérant ainsi le passage des premiers étages 16 et 22 aux deuxièmes étages 18 et 24 des deux lignes 12 et 14, l'orientation des signaux en sortie des premiers étages 16 et 22 est déterminée par le commutateur 28.

Le commutateur 28 est un commutateur à grilles croisées (aussi appelé réseau de commutation de type « cross bar »). Un commutateur de type cross bar est aisé à implémenter à partir de multiplexeurs comme le montre la figure 2. Les multiplexeurs 31 sont reliés à la sortie de chacun des premières étapes 16 et 22 des deux lignes 12 et 14.

Chaque ligne 12 et 14 comporte également un registre de mémorisation placé après le commutateur 28 mais avant l'entrée du deuxième étage 18 ou 24. Le registre de la première ligne 12 qui est relié à une sortie du commutateur 28 est le registre 30. Le registre de la deuxième ligne 14 qui est relié à une sortie du commutateur 28 est le registre 32.

Comme précédemment expliqué, le commutateur 28 permet de configurer le chemin suivi par les données entre les premier et deuxième étages. Autrement dit, cela signifie que chaque registre 30 ou 32 peut mémoriser, le signal de la sortie du premier étage 18 ou 22 de la première ligne 12 ou deuxième ligne 14.

La sortie de chacun de ces registres 30 et 32 peut être comparée par un comparateur 34. Selon l'exemple de la figure 1, le comparateur 34 est implémenté assez simplement, notamment par des portes ou exclusives. Le comparateur peut éventuellement comporter des détecteurs de métastabilité.

La sortie des différents registres 30 et 32 est également reliée respectivement à l'entrée 18E ou 24E du deuxième étage 18 ou 24 correspondant. Les deuxièmes étages 18 ou 24 agissent ainsi sur les résultats mémorisés par les registres 30 et 32.

De manière similaire, entre les deuxièmes étages 18 et 24 et les troisièmes étages 20 et 26, les première ligne 12 et deuxième ligne 14 comportent le deuxième commutateur 36. Il est du même type que le commutateur 28.

Ainsi, ce commutateur 36 comporte deux entrées et deux sorties. Les deux entrées sont reliées respectivement aux sorties 18S et 24S des deuxièmes étages. Les deux sorties sont reliées respectivement à un premier registre 38 de la première ligne 12 et à un deuxième registre 40 de la deuxième ligne 14. Le commutateur 36 peut donc orienter le signal en sortie du deuxième étage 18 vers les registres 38 et 40. Il peut faire de même avec le signal en sortie du deuxième étage 24 de la deuxième ligne 14.

La sortie de chacun des registres 38 et 40 peut être comparée par un comparateur 42. Le comparateur 42 est similaire au comparateur 34.

La sortie des deux registres 38 et 40 est reliée respectivement aux entrées 20E et 26S du troisième étage 20 ou 26 correspondant. Les troisièmes étages 20 ou 26 agissent ainsi sur les résultats mémorisés par les registres 38 et 40.

Chacun des registres, que ce soit le registre 30, 32, 38 ou 40, est relié à une horloge. Selon l'exemple de la figure 1, ce sont des bascules de type synchrone. Dans d'autres modes de réalisation, chaque registre comporte une pluralité de bascules. Chaque bascule de la figure 1 comporte une entrée de mémorisation, une sortie et une entrée d'horloge notée respectivement NE, NS et NCLOCK où N est le signe de référence de la bascule considérée. Ainsi, le registre 30 comporte une entrée 30E, une sortie 30S et une entrée d'horloge 30CLOCK. L'entrée 30E est reliée au commutateur 28 et la sortie 30S à l'entrée 18E du deuxième étage 18.

De même, le registre 32 comporte une entrée 32E, une sortie 32S et une entrée d'horloge 32CLOCK. L'entrée 32E est reliée au commutateur 28 et la sortie 32S à l'entrée 24E du deuxième étage 24.

De même, le registre 38 comporte une entrée 38E, une sortie 38S et une entrée d'horloge 38CLOCK. L'entrée 38E est reliée au commutateur 36 et la sortie 38S à l'entrée 20E du troisième étage 20.

De même, le registre 40 comporte une entrée 40E, une sortie 40S et une entrée d'horloge 40CLOCK. L'entrée 40E est reliée au commutateur 36 et la sortie 40S à l'entrée 26E du troisième étage 26.

La mémorisation du signal en entrée d'un registre n'est effective qu'à la réception d'un front de l'horloge. Par exemple, lorsque l'horloge passe à l'état haut depuis l'état bas ou inversement, une mémorisation a lieu. La synchronisation du registre sur les pulsations d'une horloge assure une stabilisation des états mémorisés. Un tel registre est parfois appelé de son nom anglais bascule « flip-flop ».

Chacun des registres 30, 32, 38 et 40 fonctionne donc avec une horloge. Les registres 30 et 38 de la première ligne fonctionnent avec une horloge notée CLOCK1.

Cette horloge CLOCK1 peut être décalée au moyen d'une ligne à retard programmable. Cela est indiqué par l'élément 44 sur la figure 1.

Des lignes à retard sont couramment utilisées au niveau des arbres d'horloge pour régler les problèmes liés au déphasage des signaux d'horloge. De ce fait leur mise en oeuvre dans le cadre de cette invention ne pose pas de problème particulier. A titre d'exemple, une ligne à retard programmable est classiquement réalisée en technologie CMOS par la mise en série de cellules de retard, puis d'un multiplexeur.

Un multiplexeur 46 permet de choisir entre le signal directement issu de l'horloge CLOCK1 ou un signal d'horloge décalé issu de l'élément 44. Cela permet un meilleur contrôle des registres 30 et 38.

Similairement les registres 32 et 40 sont contrôlés par un signal appelé CLOCK2. Ce signal peut être également décalé par une ligne à retard programmable 48. Le choix entre le signal d'horloge lui-même CLOCK2 ou le signal d'horloge retardé se fait à l'aide d'un multiplexeur 50.

De fait que les lignes 12 et 14 sont redondantes, il existe une correspondance entre les différents registres. Plus précisément, les registres 30 et 32 sont en correspondance et, de même, les registres 38 et 40 le sont également.

Il est proposé un procédé de gestion de la dégradation partielle des composants électroniques faisant partie des lignes 12 ou 14 utilisant l'architecture 10. Pour cela, il est fait usage des registres de l'autre ligne redondante.

Ainsi, le procédé comprend l'introduction d'au moins un signal électrique identique à un signal électrique présent dans la première ligne 12 dans au moins un registre de la deuxième ligne 14. Il est effectivement supposé, dans la suite, que l'état de fonctionnement est examiné pour la première ligne 12. Bien entendu, le procédé pourrait permettre également de surveiller l'état de la deuxième ligne 14 en utilisant la première ligne 12.

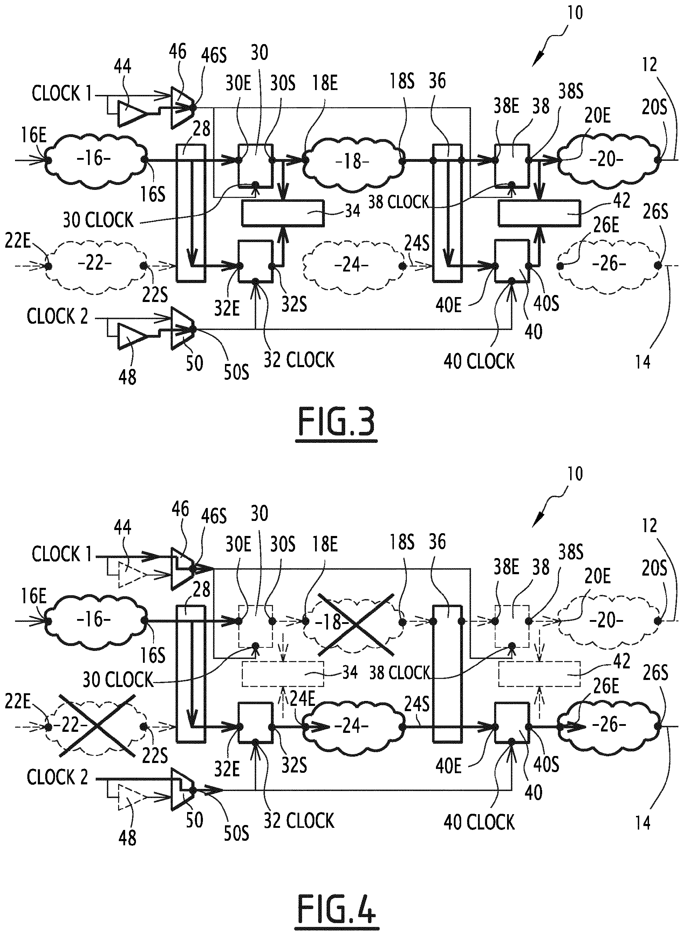

La figure 3 illustre un premier mode de réalisation du procédé de gestion proposé dans le cadre de cette invention. L'architecture 10 de la figure 3 est identique à celle de la figure 1.

L'utilisation de la figure 3 a pour objectif de permettre le diagnostic du vieillissement d'un composant électronique. En effet, le vieillissement d'un composant électronique est une des causes de dégradation partielle des composants électroniques. Le vieillissement se traduit, notamment, par un retard plus important dans les temps de réponse des composants.

Alternativement, des erreurs temporelles sûrement à cause des variations de PVT. L'acronyme PVT signifie « Process Voltage and Température » et fait référence aux différences de caractéristiques liées entre deux composants de même nature, les différences étant liées au procédé de fabrication. En effet, il est connu qu'un procédé permettant de fabriquer un composant conduit à fabriquer des composants avec des caractéristiques ayant une certaine tolérance de fabrication. Ces tolérances peuvent se traduire par des réponses temporelles différentes.

Dans cet exemple, la ligne 14 est inactive. C'est pourquoi les étages 22, 24 et 26 sont représentés en pointillés. Les composants de la deuxième ligne 14 qui sont situés dans les différents étages 22, 24 et 26 ne sont pas utilisés dans le cadre de cette utilisation. Seuls sont utilisés les registres 32 et 40.

Afin de mesurer les dégradations de la réponse temporelle des composants de la première ligne 12, l'étape d'introduction se fait en effet par envoi d'un signal électrique présent dans la première ligne 12, dans un registre 32 ou 40 de la deuxième ligne 14. Le signal de la sortie 16S est ainsi conduit par le commutateur 28 à l'entrée 32E du registre 32, ainsi que l'indiquent les flèches du schéma de la figure 3. De même, le signal en sortie du deuxième étage 18 est amené à l'entrée 40E du registre 40 par l'autre commutateur 36.

En outre, l'étape d'introduction comprend à la fois l'introduction d'un signal de la première ligne 12 dans un registre de la deuxième ligne 14 et l'introduction du même signal de la première ligne 12 dans le registre de la première ligne 12 en correspondance avec le registre de la deuxième ligne 14.

De cela, il résulte que le signal de la sortie 16S est également conduit par le commutateur 28 à l'entrée 30E du registre 30. De même, le signal en sortie du deuxième étage 18 est aussi amené à l'entrée 38E du registre 38 par l'autre commutateur 36.

Le procédé comporte alors une étape de comparaison des signaux électriques en sortie de deux registres correspondants.

Ainsi le comparateur 34 compare le signal émis par la sortie 30S du registre 30 au signal émis par la sortie 32S du registre 32. La comparaison peut porter sur l'intensité, la tension ou le décalage de ces signaux. En général, la comparaison porte sur la valeur logique des sorties 30S et 32S.

Selon l'exemple de la figure 1, en outre, le comparateur 42 compare le signal émis par la sortie 42S du registre 38 au signal émis par la sortie 32S du registre 40.

A l'aide de ces comparaisons, il peut être déterminé la dégradation partielle d'au moins un composant électronique de la première ligne 12.

Dans le cas des réponses temporelles, il est proposé que le procédé comprenne une étape de déphasage de l'horloge CLOCK2 contrôlant un registre de la deuxième ligne 14 par rapport à l'horloge contrôlant le registre correspondant de la première ligne 12. Cette horloge déphasée est ensuite envoyée vers le registre de la deuxième ligne considérée.

Pouvoir décaler les horloges CLOCK1 et CLOCK2 permet de vérifier si les marges temporelles attendues pour le composant considéré sont respectées ou non. Autrement dit, l'écart introduit par les lignes à retard 44 et 48 entre les signaux des horloges CLOCK1 et CLOCK2 correspond en réalité à la performance attendue pour les composants de l'étage 16.

Plus précisément, lorsque la comparaison s'effectue au niveau du comparateur 34, la mémorisation dans les deux registres 30 et 32 a été espacée temporellement pour correspondre aux performances attendues pour les composants situés dans le premier étage. Ainsi, si le comparateur 34 détecte une différence entre les deux sorties des bascules 30 et 32, cela signifie que l'étage 16 ne fonctionne plus aussi bien qu'auparavant.

En outre, ce mauvais fonctionnement peut être quantifié. En effet, il est possible de modifier le délai entre chacune des horloges de manière importante. Ainsi, il peut être déterminé si le décalage dû au vieillissement de l'étage 16 est conséquent ou non. Disposer d'une telle information permet de le compenser plus facilement. L'information peut également être utilisée pour prédire la défaillance d'un composant.

Un autre avantage de l'utilisation illustrée par la figure 3 est sa flexibilité. En effet, il est aisé de passer d'une configuration dans laquelle la ligne 14 est active à une configuration dans laquelle la ligne 14 est utilisée pour tester la première ligne 12, et réciproquement.

Cela permet de n'utiliser la fonction test de la deuxième ligne que lorsque cela est utile. Ceci est important dans la mesure où le vieillissement est un phénomène progressif. De ce fait, il est inutile d'effectuer un test de fonctionnement en permanence.

Il peut être notamment envisagé un diagnostic à intervalles réguliers ou au démarrage du système. Cela devrait suffire pour surveiller la dégradation du composant.

De manière alternative, le diagnostic peut également être fait lorsque des fautes apparaissent. Le diagnostic est alors utilisé pour identifier le type de fautes.

La figure 4 montre un autre avantage de l'utilisation de la figure 3. La figure 4 illustre le cas où le premier étage 22 de la deuxième ligne 14 ainsi que le deuxième étage 18 de la première ligne ne sont plus fonctionnels.

Il est alors possible de faire transiter les données depuis le premier étage 16 vers le deuxième étage 24 puis vers le troisième étage 26. Cela est rendu possible par l'emploi des commutateurs 28 et 36.

En variante, on pourrait utiliser le chemin consistant à passer par le premier étage 16, le deuxième étage 24 puis le troisième étage 20.

Il s'agit d'un mode dégradé. Mais, il est intéressant de constater que même dans ce mode dégradé, la fonction de surveillance de la dégradation partielle des composants peut être utilisée pourvu que les éléments qui sont en panne ne soient pas les registres.

Des pannes dans les composants de chacun des étages n'impliquent pas que le procédé de gestion ne puisse pas être mis en oeuvre. Autrement formulé, dans le cas où une seule ligne est encore opérationnelle, il est également possible d'utiliser en permanence les registres non utilisés de la ligne non opérationnelle.

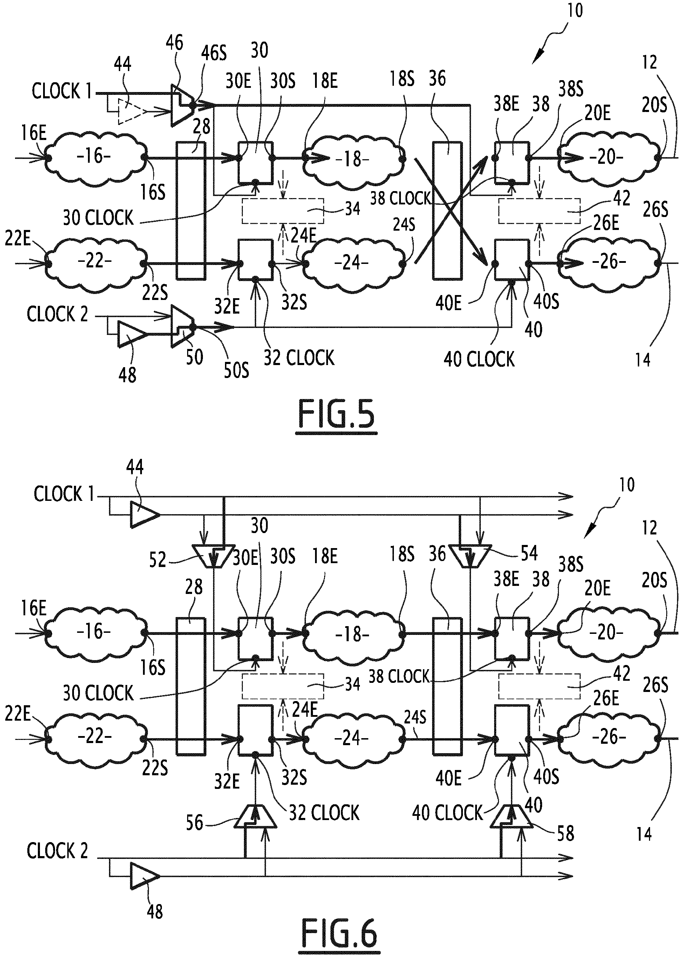

Lorsqu'une défaillance partielle a été détectée, il est généralement désiré de la compenser. La figure 5 illustre un exemple d'utilisation du schéma de la figure 3 permettant une telle compensation.

Pour cela, il est proposé de faire un échange d'horloge. Cet échange d'horloge est aussi désigné sous le terme anglais « clock-borrowing ».

Cela se fait en déphasant les horloges des deux lignes 12 et 14. Ainsi qu'expliqué plus haut, le déphasage se fait en utilisant les lignes à retard 44 ou 48.

L'utilisation du commutateur 28 ou 36 permet la compensation. En effet, le commutateur 36, à titre d'exemple, peut conduire le signal de la sortie 18S du deuxième étage 18 vers l'entrée 42E du registre 42. Le signal en sortie 24S du deuxième étage 24 est conduit vers l'entrée 38E du registre 38.

Il y a donc un échange des signaux par rapport au fonctionnement normal. En effet, il est possible de compenser un temps de propagation trop grand au niveau d'un étage, par exemple le deuxième étage 18 dans le cas qui nous intéresse, par les marges temporelles de l'étage de l'autre ligne. Autrement dit, c'est l'écart de réponse temporelle entre les deuxièmes étages 18 et 24 combiné à une bonne gestion des horloges qui permet de compenser la lenteur du deuxième étage 18.

Il apparaît, en effet, que pour les registres 30 et 38 de la première ligne 12, le contrôle se fait par CLOCK1 alors que pour les registres 32 et 40 de la deuxième ligne 14, il se fait à l'aide de CLOCK2 décalée. Dans ce mode de réalisation, CLOCK1 est en avance par rapport à CLOCK2 décalée.

Ainsi, si le signal en sortie 18S est en retard par rapport à un fonctionnement optimal, une horloge décalée peut permettre de retarder la mémorisation le signal en sortie de 18S pour assurer sa stabilité au moment de la mémorisation. Comme les deux lignes 12 et 14 sont redondantes, le traitement du signal par le troisième étage 26 est similaire à celui de l'étage 20.

Pour le signal en sortie 24S, il ne subira, au pire, dans l'opération qu'un léger retard. Ce retard non gênant puisqu'il correspondra au décalage entre CLOCK1 et CLOCK2 décalée. Du fait de l'utilisation d'une ligne à retard 48, ce décalage est donc bien contrôlé.

La différence entre les délais de propagation des deux étages de chaque ligne devra être importante pour qu'il y ait un bénéfice à l'opération. En alternative, c'est le temps de propagation du commutateur qui sera faible.

La figure 6 montre une utilisation alternative de la figure 5 permettant d'obtenir également un échange d'horloge. Selon ce mode de réalisation, l'architecture 10 est similaire. Seule la configuration des horloges CLOCK1 et CLOCK2 est différente.

En effet, les horloges ne comprennent plus un seul multiplexeur comme c'était le cas précédemment mais deux multiplexeurs, un multiplexeur par registre. Ainsi, la première ligne 12 comporte un multiplexeur 52 associé au registre 30 et un multiplexeur 54 associé au registre 38. De même, la deuxième ligne 14 comprend un multiplexeur 56 associé au registre 32 et un multiplexeur 58 associé au registre 40.

Le multiplexeur 52 et le multiplexeur 54 permettent de choisir entre le signal CLOCK1 directement et le signal CLOCK1 décalé respectivement dans les entrées 30CLOCK et 38CLOCK. Le multiplexeur 56 et le multiplexeur 58 permettent de choisir entre le signal CLOCK2 et le signal CLOCK2 décalé respectivement entre les entrées 32CLOCK et 42CLOCK.

Pour obtenir le même résultat que dans l'utilisation proposée dans le cadre de la figure 5, les délais introduits par les lignes à retard ne sont pas quelconques. En considérant l'exemple de CLOCK1, cela implique que soit CLOCK1 correspond à CLOCK2 ou à CLOCK2 décalée, soit CLOCK1 décalée correspond à CLOCK2 ou à CLOCK2 décalée.

De cette manière, il peut être considéré que l'utilisation de la figure 6 revient à envoyer un signal issu de la première ligne dans au moins un des registres de la deuxième ligne. En effet, une des horloges que ce soit l'horloge CLOCK2 ou l'horloge CLOCK2 décalée corresponde à CLOCK1 ou à CLOCK1 décalée.

Dans ce mode de réalisation, l'étape d'introduction se fait ainsi par génération d'un signal électrique identique à un signal électrique présent dans la première ligne 12, le signal généré étant ensuite envoyé au registre de la deuxième ligne 14.

De manière alternative, cette utilisation octroyant une grande flexibilité, si le deuxième étage 18 est plus lent que prévu et que le troisième étage 20 est plus rapide, il est possible d'utiliser CLOCK1 décalée pour le registre 38 et d'utiliser CLOCK2 pour l'ensemble de la deuxième ligne 14. Si c'est le premier étage 16 qui est plus lent que prévu, CLOCK1 décalée peut être utilisée pour les registres 30 et 38.

Le procédé proposé peut s'étendre à des architectures avec une redondance plus importante qu'une redondance double. En effet, la présence d'un grand nombre d'éléments redondants octroie plus de flexibilité dans la gestion des différents modes de fonctionnement.

A titre d'exemple, dans le cas d'une architecture avec une triple redondance (trois lignes), il peut être considéré un fonctionnement avec une ligne active et les deux autres lignes surveillant le vieillissement de la première ligne. Le fait d'avoir deux lignes mesurant la dégradation du composant permet d'évaluer plus rapidement les marges temporelles en utilisant des délais différents au niveau des horloges des deux lignes de tests.

De manière alternative, il peut être considéré un fonctionnement avec deux lignes actives, que ce soit en mode lockstep ou indépendantes l'une de l'autre, alors que la troisième est inactive et mesure le vieillissement.

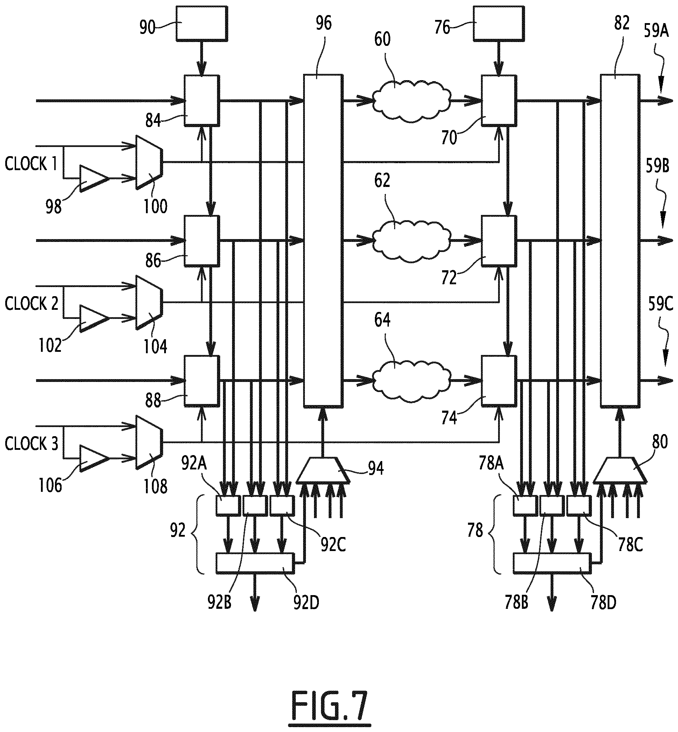

Dans le cas d'une architecture avec de la redondance triple, l'architecture peut facilement être enrichie avec un mode de fonctionnement supportant la correction d'erreurs. La figure 7 montre une telle extension de l'architecture 10 de la figure 3 pour la correction d'erreurs.

L'architecture 10 de la figure 7 comporte trois lignes 59A, 59B, 59C. Ces trois lignes sont redondantes.

Selon l'exemple de la figure 7, ces trois lignes ne comportent qu'un seul étage. Il s'agit de l'étage 60 pour la ligne 59A, de l'étage 62 pour la ligne 59B, de l'étage 64 pour la ligne 59C. Comme les lignes sont redondantes, les composants électroniques de chacun des étages sont correspondants. Cela signifie que pour un même signal en entrée de l'étage 60, de l'étage 62 ou de l'étage 64, le signal en sortie résultant est le même.

Chaque étage est relié à un registre. Ainsi, l'étage 60 est relié à un registre 70, l'étage 62 est relié à un registre 72 et l'étage 64 à un registre 74.

Selon l'exemple de la figure 7, les registres 70, 72 et 74 sont des bascules telles que décrites précédemment. Ces registres sont reliés à un générateur de motifs de tests 76.

Le générateur 76 est intégré sur la puce. Le générateur 76 est appelé TPG ou « Test Pattern Generator ». Il a pour rôle de distribuer des vecteurs de tests à l'entrée de tous les registres 70, 72 et 74. Les vecteurs de tests peuvent être utilisés puisque les éléments sont répliqués à l'identique.

Le générateur 76 peut être utilisé pour détecter les défauts de fabrication ou les fautes permanentes des composants des lignes 60, 62 ou 64.

Selon cette figure 7, il est implémenté un voteur 78 qui détecte la majorité des signaux issus de comparateurs 78A, 78B et 78C comparant deux à deux la sortie des registres 70, 72 et 74. Le voteur 78 comporte un calculateur 78D de vote. L'emploi du calculateur 78D repose sur le fait qu'il est peu probable que deux dysfonctionnements identiques surviennent en même temps. La sortie du calculateur 78D est envoyée dans un multiplexeur 80 permettant de contrôler un commutateur 82.

Le voteur 78 permet de supporter un dysfonctionnement dans un étage 60, 62 ou 64. Le dysfonctionnement est dû à une dégradation ou à tout autre erreur. Si un étage est défectueux, deux comparateurs indiquent la présence d'une erreur. Par exemple, si l'étage 64 est défectueux, les deux comparateurs 78A et 78B indiquent une erreur. A partir des signaux des comparateurs 78A, 78B et 78C, le calculateur 78D déduit qu'une faute s'est produite à l'étage 64. Il programme alors le commutateur 12 pour que la ligne 59A prenne la valeur du registre 70, la ligne 59B celle du registre 72 et la ligne 59C celle du registre 70 ou 72 et pas la valeur du registre 74 qui est incorrecte.

Dans cet exemple, le calculateur 78D effectue le vote à chaque front de l'horloge qui le contrôle.

En variante, le calculateur 78D est propre à informer d'autres parties de l'architecture 10 qu'une faute a été détectée.

Dans le cas de la figure 7, les éléments en amont des étages 60, 62 et 64 sont aussi décrits. Ils sont similaires à ce qui vient d'être décrit et qui concerne l'aval de ces étages 60, 62 et 64.

Des registres 84, 86 et 88 sont ainsi également présents. Ils sont toujours contrôlés par un générateur 90 de tests.

En outre, un commutateur 96 est contrôlé par la sortie d'un voteur 92 comportant trois comparateurs 92A, 92B et 92C et un calculateur 92D de vote via un multiplexeur 94.

Pour chacune des configurations que ce soit la configuration aval et/ou amont, le contrôle des différents registres se fait à l'aide d'horloges.

Les registres 84 et 70 sont contrôlés par une horloge CLOCK1 ou, le cas échéant, son signal décalé à l'aide d'une ligne à retard 98. Le choix entre les deux signaux se fait à l'aide d'un multiplexeur 100.

Les deux registres 72 et 86 sont contrôlés soit par un signal d'horloge CLOCK2 soit par ce signal CLOCK2 décalé. Le signal CLOCK2 décalé est généré à l'aide d'une ligne à retard 102. Un multiplexeur 104 permet de choisir entre le signal CLOCK2 ou le signal CLOCK2 décalé.

Les bascules 74 et 88 sont, de même, contrôlées par une horloge CLOCK3 qui peut également être décalée. Le décalage se fait par une ligne à retard 106. Le choix entre les deux horloges se fait à l'aide d'un multiplexeur 108.

L'architecture proposée à la figure 7 est donc une autre manière d'implémenter un procédé de gestion de la dégradation partielle de composants électroniques. Les commutateurs 82 et 96 sont, en effet, placés en sortie des registres et non en entrée, au contraire des montages présentés précédemment.

Dans ce mode de réalisation, le générateur 76, assure que des signaux identiques circulent sur les registres 70, 72 et 74 et le générateur de tests 90 assure la même chose pour les registres 84, 86 et 88. Ces générateurs 76 et 90 peuvent, en effet, détecter des défauts de fabrication ou des fautes permanentes.

Les voteurs 78 et 94 permettent aussi d'obtenir une détection et une correction d'erreur en permanence.

Les comparateurs 78A, 78B, 78C, 92A, 92B et 92C peuvent utilisés pour mesurer la dégradation ainsi que cela a été décrit précédemment.

Dans tous les modes de réalisation proposés, le procédé présenté est adapté à des applications plus ou moins critiques. Cela permet de viser des applications dans des domaines d'utilisation relativement larges. Dans le cas d'applications très critiques, comme l'architecture peut fonctionner comme une architecture DMR ou TMR (respectivement « Dual Modular Redundancy ou « Triple Modular Redundancy »), l'architecture 10 permet de surveiller la dégradation du composant afin d'anticiper ses défaillances et d'établir un diagnostic. Dans le cadre d'applications moins critiques, les lignes peuvent être utilisées de façon indépendante et le mode de diagnostic être utilisé de manière à prédire l'apparition de défaillances.

Cette flexibilité dans les ressources matérielles permet une gestion optimale de ces ressources. Cette gestion est optimisée en prenant en compte les caractéristiques du composant fabriqué, sa dégradation réelle et en permettant une exploitation maximale même après les premier signes de dégradation. Cela s'explique par le fait que la redondance et les mécanismes de reconfiguration permettent de supporter les fautes permanentes, même partielles.

L'architecture proposée a donc l'avantage de pouvoir exploiter à la fois la redondance spatiale et la redondance temporelle, le tout sans nécessiter un surcoût matériel important.

Sont néanmoins employées des lignes à retards et/ou des commutateurs. Même si ces éléments de l'architecture devaient être peu utilisés (utilisation avec une surveillance du vieillissement périodique) et donc soumis au vieillissement, ces éléments pourraient néanmoins être conçus de façon être plus robustes à l'usure avec un surdimensionnement des transistors par exemple. L'impact de cette surface additionnelle et la consommation qui en résulte est de toute façon négligeable compte tenu de la faible complexité de cet élément.

La gestion des différents modes de fonctionnement peut être programmée et correspondre à des modes de sûreté de fonctionnement. Une gestion matérielle aussi bien que logicielle est possible.

Cette possibilité de surveillance du vieillissement a un intérêt tout particulièrement dans les applications critiques avec de longues durées de vie.

A titre d'exemple, l'avionique, le spatial et l'automobile sont des domaines d'application. Ces domaines d'application combinent à la fois de fortes exigences en termes de fiabilité et de durée de vie.

Le procédé proposé pourra être implémenté dans des ASICS et des processeurs dédiés pour ce type d'applications.

Un ASIC (acronyme de l'anglais « Application-Specific Integrated Circuit », qui signifie littéralement « circuit intégré propre à une application ») est un circuit intégré spécialisé regroupant généralement un grand nombre de fonctionnalités uniques et/ou sur mesure.

Bien entendu, il peut s'appliquer à tout type de circuit intégré comprenant des parties logiques redondantes. Ceci peut inclure aussi bien des circuits basiques, des systèmes sur puce « on chip » selon la terminologie anglaise ou des processeurs.

Cela inclut notamment les processeurs multicores ou multithreads. Le procédé pourrait également être utilisé localement dans le cadre d'architectures SIMD (ou « Single Instruction Multiple Data »), VLIW (ou « Very Long Instructions Word ») ou superscalaires. En outre, le procédé est aussi adapté pour des accélérateurs programmables ou déviés comportant de la redondance.

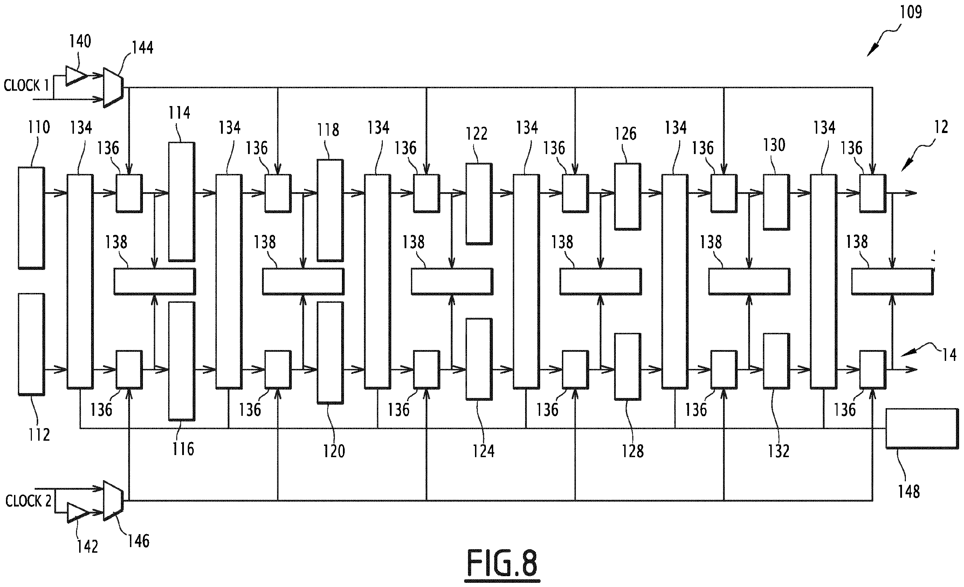

Ce procédé est particulièrement adapté aux processeurs multicoeur. Ce sont en effet des applications particulièrement critiques. La figure 8 représente un schéma simplifié d'une architecture 109 multicoeur basée sur le procédé proposé. Dans un souci de clarté, aucun chemin de retour n'est représenté sur la figure. Cependant, l'invention proposée peut tout à fait prendre en compte de tels chemins.

Le schéma de la figure 8 correspond au schéma de la figure 3 précédemment présentée avec un nombre plus important d'étages. Les premiers étages 110 et 112 correspondent à la lecture d'une instruction en mémoire. Les deuxièmes étages effectuent des opérations de décodage. Les troisièmes étages 118 et 120 correspondent à la lecture d'instructions vers la réalisation. Les quatrièmes étages 122 et 124 sont dédiés à l'exécution des données. Les cinquièmes étages 126 et 128 sont les étages de mémorisation qui permettent d'écrire ou de lire sur une mémoire et, enfin, les sixièmes étages 130 et 132 sont les étages d'écriture dans le processeur. Entre chacun de ces étages, comme dans l'invention présentée, se trouvent des commutateurs 134, des bascules 136 et des comparateurs 138 comparant la sortie de chacune de ces bascules 136. Le contrôle des bascules 136 utilise des signaux d'horloge CLOCK1 et CLOCK2, des lignes à retard 140 et 142 associées respectivement à des multiplexeurs 144 et 146. Un module de contrôle 148, est, en outre, propre à contrôler les commutateurs 134.

Là encore, le procédé de gestion peut être appliqué pour surveiller le vieillissement des différents étages.

## Revendications

1. Procédé de gestion de la dégradation partielle de composants électroniques faisant partie d'une architecture (10) de traitement de données comportant une pluralité de lignes de traitement de données dont :
- une première ligne (12) de traitement de données,
- une deuxième ligne (14) de traitement de données, au moins les première et deuxième lignes (12, 14) étant redondantes et munies de registres (30, 32, 38, 40) de mémorisation en correspondance,
**caractérisé en ce que** :
- le procédé comprend une étape d'introduction dans au moins un registre (32, 40) de la deuxième ligne (14) d'au moins un signal électrique identique à un signal électrique présent dans la première ligne (12) par envoi d'un signal électrique présent dans la première ligne (12) dans un registre (32, 40) de la deuxième ligne (14),
- la première ligne (12) et la deuxième ligne (14) sont munies d'un commutateur (28, 36) adapté à orienter les signaux d'une ligne vers l'une des deux lignes (12, 14) ou les deux lignes (12, 14), l'étape d'introduction étant réalisée à l'aide du commutateur (28, 36),
- l'étape d'introduction comprend à la fois l'introduction d'un signal de la première ligne (12) dans un registre (32, 40) de la deuxième ligne (14) et l'introduction du même signal de la première ligne (12) dans le registre (30, 38) de la première ligne (12) en correspondance avec le registre de la deuxième ligne (14), et
- le procédé comporte, en outre, une étape de :
- comparaison des signaux électriques en sortie des deux registres (30, 32, 38, 40) correspondants,
- détermination de la dégradation partielle d'au moins un composant électronique de la première ligne (12), à partir de cette comparaison.

2. Procédé selon la revendication 1, **caractérisé en ce que** le procédé comporte une étape de :
- déphasage d'une horloge (CLOCK2) contrôlant un registre (32, 40) de la deuxième ligne (14) par rapport à une horloge (CLOCK1) contrôlant un registre (30, 38) correspondant de la première ligne (12),
- envoi de l'horloge (CLOCK2) déphasée vers le registre (32, 40) de la deuxième ligne (14),
l'étape de détermination de la dégradation partielle comportant une détermination du temps de réponse du composant considéré.

3. Procédé selon la revendication 2, **caractérisé en ce que** le déphasage de l'horloge (CLOCK2) correspond au temps de réponse attendu pour le composant électronique testé.

4. Procédé selon la revendication 3, **caractérisé en ce que** l'étape de détermination de la dégradation partielle comporte également :
- une étape de comparaison du temps de réponse déterminé du composant au temps de réponse attendu et
- une étape de détection d'un vieillissement du composant testé dans le cas où le temps déterminé est supérieur au temps de réponse attendu.

5. Procédé selon la revendication 4, **caractérisé en ce que** le procédé comprend en outre une étape de compensation de la différence de temps entre le temps déterminé et le temps de réponse attendu pour le composant.

6. Procédé selon la revendication 5, **caractérisé en ce que** l'étape de compensation est réalisée par échange des signaux d'entrées entre deux registres (30, 32, 38, 40) en correspondance des deux lignes (12, 14), un signal de la première ligne (12) alimentant le registre (32, 40) de la deuxième ligne (14) et le signal correspondant de la deuxième ligne (14) alimentant le registre (30, 38) correspondant de la première ligne (12).

7. Procédé selon la revendication 5, **caractérisé en ce que** l'étape de compensation est réalisée par échange des signaux d'horloge (CLOCK1, CLOCK2) entre deux registres (30, 32, 38, 40) en correspondance des deux lignes (12, 14), un signal identique à un signal d'horloge (CLOCK1) de la première ligne (12) alimentant le registre (32, 40) de la deuxième ligne (14) et un signal identique à un signal d'horloge (CLOCK2) de la deuxième ligne (14) alimentant le registre (30, 38) correspondant de la première ligne (12).

8. Procédé selon l'une des revendications 1 à 7, **caractérisé en ce que** l'architecture (10) de traitement de données comporte une troisième ligne redondante avec les première et deuxième lignes (12,14), les trois lignes étant munies de registres et de commutateurs en correspondance, **en ce que** les registres et les commutateurs sont pourvus d'au moins une entrée et un sortie et **en ce que** les entrées des commutateurs sont reliés à des sorties des registres.

9. Une architecture (10) de traitement de données comportant une pluralité de lignes de traitement de données dont :
- une première ligne (12) de traitement de données,
- une deuxième ligne (14) de traitement de données, au moins les première et deuxième lignes (12, 14) étant redondantes et munies de registres de mémorisation en correspondance,
**caractérisée en ce que** l'architecture est adaptée pour la mise en oeuvre du procédé selon l'une quelconque des revendications 1 à 7.

10. Un processeur comportant plusieurs coeurs, **caractérisé en ce que** chaque coeur comporte une architecture selon la revendication 9.

## Patentansprüche

1. Verfahren zur Handhabung des partiellen Abbaus von elektronischen Bauteilen als Teil einer Datenverarbeitungsarchitektur (10), umfassend eine Vielzahl von Datenverarbeitungsleitungen, davon:
- eine erste Datenverarbeitungsleitung (12),
- eine zweite Datenverarbeitungsleitung (14), wobei mindestens die erste und zweite Leitung (12, 14) redundant sind und mit korrespondierenden Speicherregistern (30, 32, 38, 40) ausgestattet sind,
**dadurch gekennzeichnet, dass**:
- das Verfahren eine Eingabeschritt in mindestens ein Register (32, 40) der zweiten Leitung (14) mindestens eines elektrischen Signals umfasst, das mit einem elektrischen Signal identisch ist, das in der ersten Leitung (12) vorhanden ist, durch Senden eines elektrischen Signals, das in der ersten Leitung (12) vorhanden ist, in ein Register (32, 40) der zweiten Leitung (14),
- die erste Leitung (12) und die zweite Leitung (14) mit einem Schalter (28, 36) ausgestattet sind, der imstande ist, die Signale einer Leitung zu einer der zwei Leitungen (12, 14) der den zwei Leitungen (12, 14) zu orientieren, wobei der Eingabeschritt mit Hilfe des Schalters (28, 36) durchgeführt wird,
- der Eingabeschritt gleichzeitig die Eingabe eines Signals der ersten Leitung (12) in ein Register (32, 40) der zweiten Leitung (14) und die Eingabe desselben Signals der ersten Leitung (12) in das Register (30, 38) der ersten Leitung (12) in Korrespondenz mit dem Register der zweiten Leitung (14) umfasst, und
- das Verfahren ferner einen Schritt umfasst des:
- Vergleichens der elektrischen Signale am Ausgang der zwei entsprechenden Register (30, 32, 38, 40),
- Bestimmens des teilweisen Abbaus mindestens eines elektronischen Bauteils der ersten Leitung (12) auf der Basis dieses Vergleichs.

2. Verfahren nach Anspruch 1, **dadurch gekennzeichnet, dass** das Verfahren einen Schritt umfasst:
- der Phasenregelung einer Uhr (CLOCK2), die ein Register (32, 40) der zweiten Leitung (14) kontrolliert in Bezug auf eine Uhr (CLOCK1), die ein entsprechendes Register (30, 38) der ersten Leitung (12) kontrolliert,
- des Versands der phasengeregelten Uhr (CLOCK2) zum Register (32, 40) der zweiten Leitung (14),
wobei der Bestimmungsschritt des teilweisen Abbaus eine Bestimmung der Antwortzeit des entsprechenden Bauteils aufweist.

3. Verfahren nach Anspruch 2, **dadurch gekennzeichnet, dass** die Phasenregelung der Uhr (CLOCK2) der erwarteten Antwortzeit für das getestete elektronische Bauteil entspricht.

4. Verfahren nach Anspruch 3, **dadurch gekennzeichnet, dass** der Bestimmungsschritt des teilweisen Abbaus ebenfalls aufweist:
- eine Vergleichschritt der bestimmten Antwortzeit des Bauteils mit der erwarteten Antwortzeit, und
- einen Detektionsschritt einer Alterung des getesteten Bauteils für den Fall, dass die bestimmte Antwortzeit größer als die erwartete Antwortzeit ist.

5. Verfahren nach Anspruch 4, **dadurch gekennzeichnet, dass** das Verfahren ferner einen Ausgleichsschritt der Zeitdifferenz zwischen der bestimmten Antwortzeit und der für das Bauteil erwarteten Antwortzeit umfasst.

6. Verfahren nach Anspruch 5, **dadurch gekennzeichnet, dass** der Ausgleichsschritt durch Austausch der Eingangssignale zwischen zwei Registern (30, 32, 38, 40) in Korrespondenz der zwei Leitungen (12, 14) durchgeführt wird, wobei ein Signal der ersten Leitung (12) das Register (32, 40) der zweiten Leitung (14) versorgt und das entsprechende Signal der zweiten Leitung (14) das entsprechende Register (30, 38) der ersten Leitung (12) versorgt.

7. Verfahren nach Anspruch 5, **dadurch gekennzeichnet, dass** der Ausgleichsschritt durch Austausch der Zeitsignale (CLOCK1, CLOCK2) zwischen zwei Registern (30, 32, 38, 40) in Korrespondenz der zwei Leitungen (12, 14) durchgeführt wird, wobei ein Signal, das mit einem Zeitsignal (CLOCK1) der ersten Leitung (12) identisch ist, das Register (32, 40) der zweiten Leitung (14) versorgt, und ein Signal, das mit einem Zeitsignal (CLOCK2) der zweiten Leitung (14) identisch ist, das entsprechende Register (30, 38) der ersten Leitung (12) versorgt.

8. Verfahren nach einem der Ansprüche 1 bis 7, **dadurch gekennzeichnet, dass** die Datenverarbeitungsarchitektur (10) eine dritte, mit der ersten und zweiten Leitung (12, 14) redundante Leitung aufweist, wobei die drei Leitungen mit Registern und Schaltern in Korrespondenz ausgestattet sind, dass die Registers und die Schalters mit mindestens einem Eingang und einem Ausgang ausgestattet sind und dass die Eingänge der Schalters mit den Ausgängen der Register verbunden sind.

9. Datenverarbeitungsarchitektur (10), aufweisend eine Vielzahl von Datenverarbeitungsleitungen, davon:
- eine erste Datenverarbeitungsleitung (12),
- eine zweite Datenverarbeitungsleitung (14), wobei mindestens die erste und zweite Leitung (12, 14) redundant sind und mit korrespondierenden Speicherregistern ausgestattet sind,
**dadurch gekennzeichnet, dass** die Architektur für die Umsetzung des Verfahrens nach einen der Ansprüche 1 bis 7 geeignet ist.

10. Prozessor, umfassend mehrere Kerne, **dadurch gekennzeichnet, dass** jeder Kern eine Architektur nach Anspruch 9 aufweist.

## Claims

1. A method for handling partial degradation of electronic components belonging to an architecture (10) for processing data including a plurality of data processing lines including:
- a first data processing line (12),
- a second data processing (14), at least the first and second lines (12, 14) being redundant and provided with registers (30, 32, 38, 42) for matching storage in memory,
**characterized in that**:
- the method comprises a step for introducing into at least one register (32, 40) of the second line (14) at least one electric signal identical with an electric signal present in the first line (12) by sending an electric signal present in the first line (12), into one register (32, 40) of the second line (14),
- the first line (12) and the second line (14) are provided with a switch (28, 36) suitable for orienting the signals from one line to one of both lines (12, 14) or to both lines (12, 14), the introduction step being carried out by means of the switch (28, 36),
- the introduction step comprises are both the introduction of a signal from the first line (12) into a register (32, 40) of the second line (14) and the introduction of the same signal of the first line (12) into the register (30, 38) of the first line (12) matching the register of the second line (14), and
- the method further includes a step for:
- comparing the electric signals at the output of both corresponding registers (30, 32, 38, 40),
- determining the partial degradation of at least one electronic component of the first line (12), from this comparison.

2. The method according to claim 1, **characterized in that** the method includes a step for:
- phase-shifting a clock (CLOCK2) controlling a register (32, 40) of the second line (14) relatively to a clock (CLOCK1) controlling a corresponding register (30, 38) of the first line (12),
- sending the phase-shifted clock (CLOCK2) to the register (32, 40) of the second line (14),
the step for determining the partial degradation including a determination of the response time of the relevant component.

3. The method according to claim 2, **characterized in that** the phase shift of the clock (CLOCK2) corresponds to the expected response time for the tested electronic component.

4. The method according to claim 3, **characterized in that** the step for determining the partial degradation also includes:
- a step for comparing the determined response time of the component with the expected response time, and
- a step for detecting ageing of the tested component in the case when the determined time is greater than the expected response time.

5. The method according to claim 4, **characterized in that** the method also comprises a step for compensating the time difference between the determined time and the expected response time for the component.

6. The method according to claim 5, **characterized in that** the compensation step is carried out by exchanging input signals between two matching registers (30, 32, 38, 40) of both lines (12, 14), a signal of the first line (12) feeding the register (32, 40) of the second line (14) and the corresponding signal of the second line (14) feeding the corresponding register (30, 38) of the first line (12).

7. The method according to claim 5, **characterized in that** the compensation step is carried out by exchanging clock signals (CLOCK1, CLOCK2) between two matching registers (30, 32, 38, 40) of both lines (12, 14), a signal identical with a clock signal (CLOCK1) of the first line (12) feeding the register (32, 40) of the second line (14) and a signal identical with a clock signal (CLOCK2) of the second line (14) feeding the corresponding register (30, 38) of the first line (12).

8. The method according to one of claims 1 to 7, **characterized in that** the data processing architecture (10) includes a third line, redundant with the first and second lines (12, 14), the three lines being provided with matching registers and switches, **in that** the registers and switches are provided with at least one input and one output and **in that** the inputs of the switches are connected to the outputs of the registers.

9. A data processing architecture (10) including a plurality of data processing lines including:
- a first data processing line (12),
- a second data processing line (14), at least the first and second lines (12,14) being redundant and provided with matching memory storage registers,
**characterized in that** the architecture is suitable for applying the method according to any of claims 1 to 7.

10. A processor including several cores, **characterized in that** each core includes an architecture according to claim 9.
